# EUROPEAN PATENT APPLICATION

(11) **EP 1 244 313 A1**
(43) Date of publication of application: **25.09.2002**
(21) Application number: 01302502.8
(22) Date of filing: 19.03.2001
(51) Int. Cl.: H04Q 1/14, H05K 7/14

(54) **Rack device for telecommunication equipment**

(71) Applicant: LUCENT TECHNOLOGIES INC., Murray Hill, New Jersey 07974-0636 (US)
(72) Inventor: Henzen, Theo Hendrikus, Zeewolde 3892 HW (NL)
(74) Representative: Sarup, David Alexander

(57) **Abstract**

Rack device for telecommunication equipment including a housing for circuit packs and a back panel having an extended section extending at least at one side of said housing beyond the housing in order to provide a mounting area for at least one interface connector part. The extended back panel section supports a number of connector parts suitable for connecting to connector parts of a number of interface modules, which again have further connector parts adapted to user specifications for connecting to other equipment.

## Description

This invention relates to a rack device for telecommunication equipment including a housing for circuit packs and a back panel extending at least at one side of said housing beyond the housing in order to provide a mounting area for at least one interface connector.

The invention further relates to a rack device system including at least one rack device and a number of interface modules.

Rack devices for mounting circuit packs for telecommunications are well known in the art. Often a plurality of rack devices, usually called subracks, are mounted in a cabinet. Each subrack must be designed to facilitate connection to customer equipment. To this end, in the known rack devices an extended back panel is provided, usually extending a certain distance above or below the circuit pack area.

On said extended back panel, which as an alternative may extend laterally to the circuit pack area or even above the circuit pack area, interface connectors are provided.

A problem with such an arrangement is that in case a customer requires a different type of interface connector either a complete new back panel has to be developed or conversion cables are rather costly and time-consuming.

It is a goals of the present invention to substantially eliminate the above problem and more generally to provide a more universally applicable rack device of the type described above. In order to attain said goal a rack device in accordance with the present invention is characterized by an extended back panel section which supports a number of connector parts suitable for connecting to connector parts of a number of interface modules, which again have further connector parts adapted to user specifications for connecting to other equipment.

The invention will be explained in more detail with reference to the attached drawing of some embodiments of a rack device according to the invention.
Fig. 1 schematically shows an example of a rack device, as well as its use in controlled or uncontrolled environments;
fig. 2 schematically shows in front view an example of an embodiment of a rack device of the invention;
fig. 3 schematically shows the rack device of fig. 2 in side view;
figs. 4 and 5 schematically show an example of an embodiment of a rack device in accordance with the present invention in front view and side view respectively;
figs. 6 and 7 schematically show an example of another embodiment of an inventive rack device in front view and side view respectively; and
figs. 8 and 9 schematically show an example of a further embodiment of an inventive rack device in front view and side view respectively.

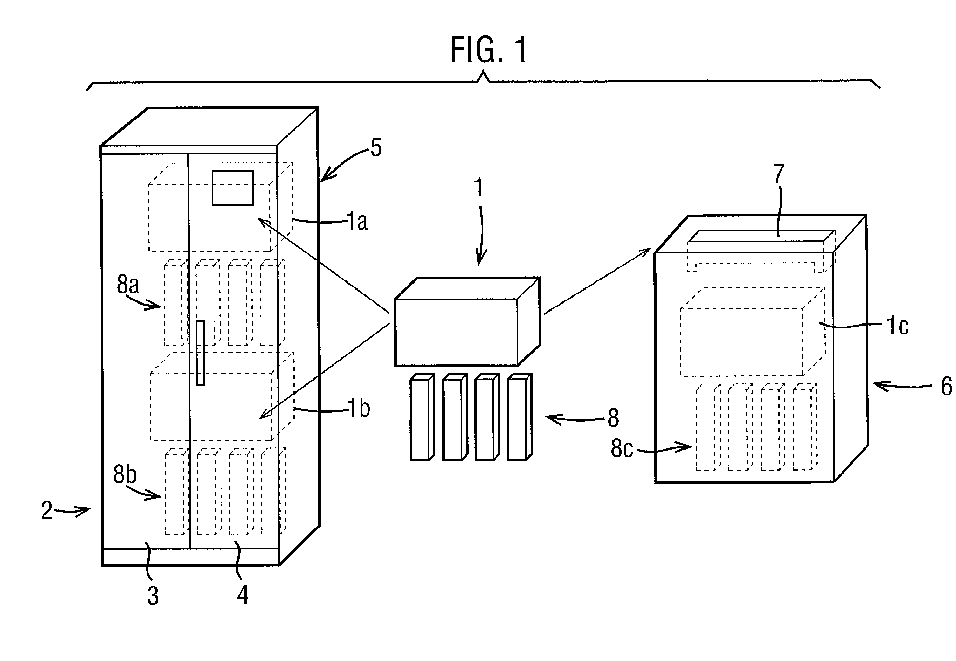

Fig. 1 schematically shows a rack device 1 which may be used in cabinets with different sizes, for instance a high skin cabinet for office application as shown at the left hand side of fig. 1. A cabinet 2 has front doors 3,4 and in the cabinet two rack devices 1a, 1b have been mounted against the back wall 5 of the cabinet.

At the right hand side of fig. 1 a rack device 1c is shown mounted in a low wide cabinet, in this example a protective box 6 for use in uncontrolled environments. The box 6 further includes a climate control apparatus 7. Below each of the rack devices a set 8, 8a, 8b, 8c of interface modules has schematically been shown. The interface modules will be explained in more detail below.

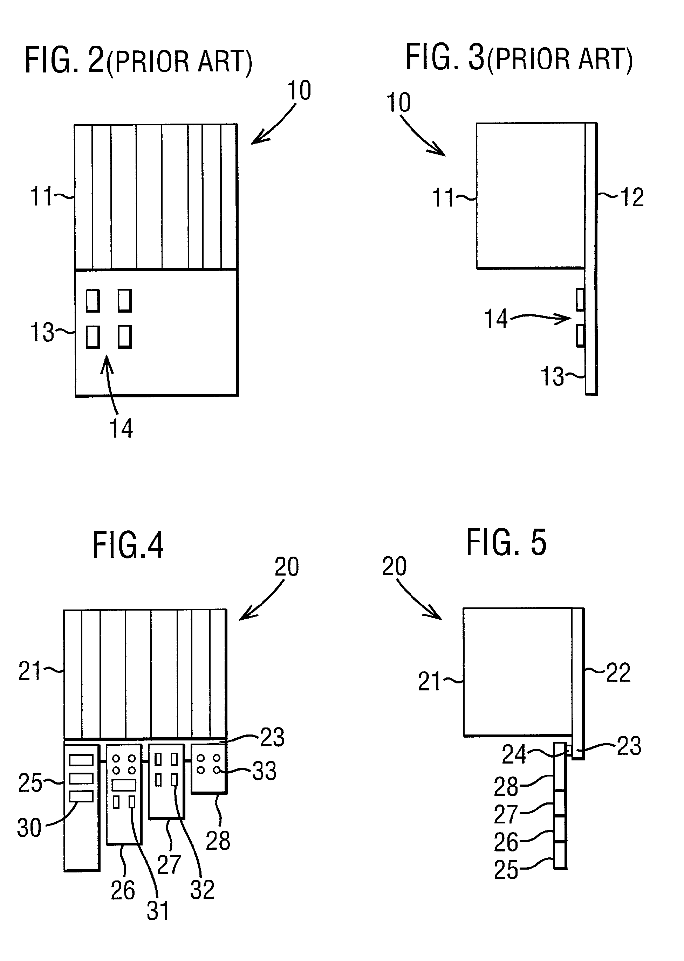

Fig. 2 and fig. 3 schematically show in front and side view a prior art front access subrack 10 for telecommunication equipment having a circuit pack area in housing 11 and a back panel 12 having an extended section 13, in this example extending below said housing. The extended back panel section 13 supports a number of interface connector parts 14. Said interface connector parts 14 are connected through the back panel to the electronics in the circuit packs and will be used for connection of other equipment through mating connecting parts (not shown). Such connections are made by a user of the subracks during installation in the field.

A problem is that the amount of these connections and the required space therefor is very large. Further, interface types usually vary from user to user and also the type of connector prescribed may vary from user to user. Until now specific user demands would be accommodated by adapting the back panel and connector parts or by providing custom made conversion cables.

Fig. 4 and fig. 5 schematically show an example of an inventive rack device 20, again including a front access circuit pack area in a housing 21 and a back panel 22. The back panel 22 of the inventive device differs from the back panel 12 of the prior art design in that it has a number of standardized connector parts 24 provided on a back panel section 23 which only slightly extends below the circuit pack area 21. The standardized connector parts 24 in fact are interconnector parts which will be prefabricated independent from user demands and on which interface modules will be plugged. Fig. 4 schematically shows a number of such interface modules 25-28. The modules each have a backside connector part mating to the standardized connector parts 24 on the back panel section 23. Further each module has a number of connectors in accordance with user demand as schematically indicated at 30-33. The standardized connector parts preferably are miniature connector parts that only need a small amount of space. In that case the extended back panel section may be rather narrow. The system height now has become dependent on the type of interface and the type of connector specified by the user. Thus the amount of space necessary for a rack device has become flexible. If a user might be able to use miniature connectors and cable it may be possible to mount e.g. three or four rack devices instead of two or five instead of three etc. in a vertical column in an existing cabinet.

Also the rack device may be prefabricated in standardized dimensions and with standardized interconnector parts. Only the comparatively small interface modules will have to be made to user demand.

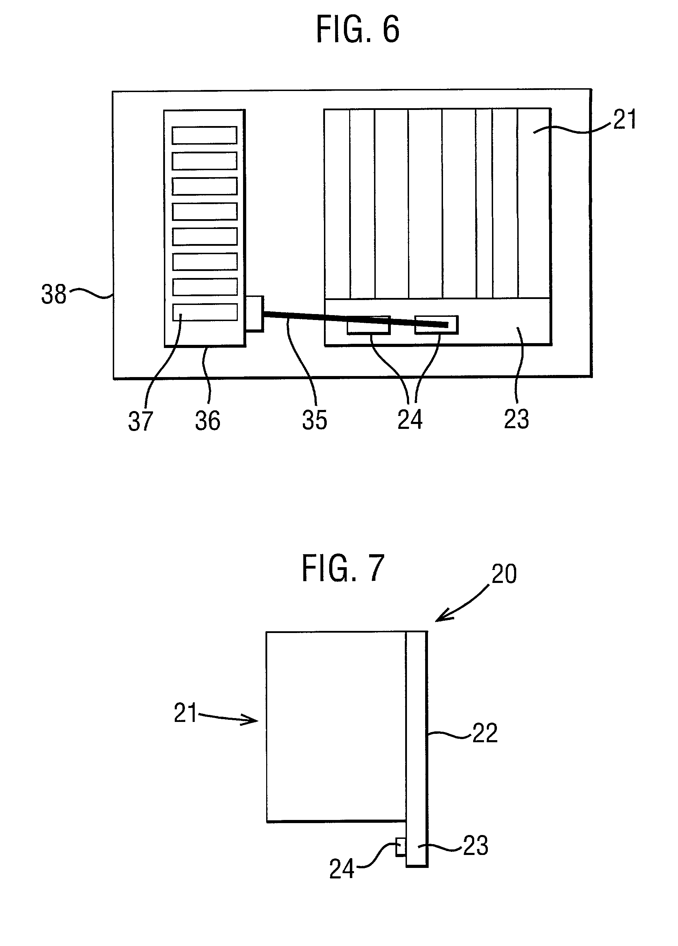

Fig. 6 and fig. 7 schematically show in front and side view another embodiment of a rack device in accordance with the present invention. The extended striplike section 23 of back panel 22 of rack device 20 in this embodiment has two connector parts 24 which through mating connector parts and one or more cables 35 are connected to an interface module 36 mounted at the left hand side of the rack device 20. The interface module 36 again has a number of connectors 37 for use for connections to peripheral equipment. This is a typical lay-out for street cabinets 38 or wall mounted installations.

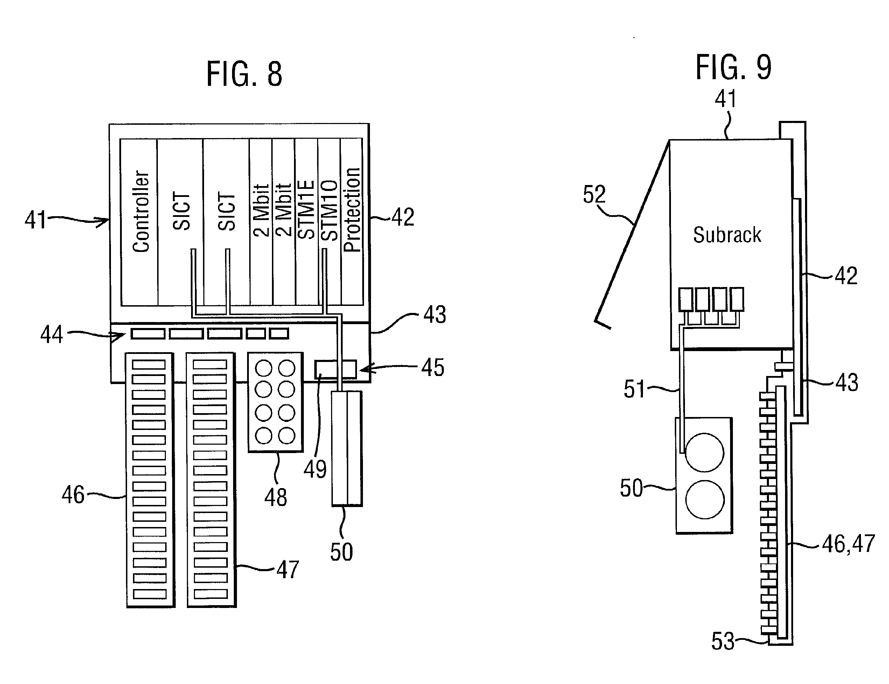

Fig. 8 and fig. 9 schematically show a further example of an embodiment of a rack device in accordance with the present invention. In the circuit pack area in a housing 41 a number of circuit packs have been inserted. A back panel 42 has an extension 43 at its lower end. In this embodiment the extension supports two rows 44, 45 of connector parts. The upper row 44 is for miscellaneous I/O connections and is not in use in the situation shown. In the connector parts of a lower row 45 a number of I/O modules, in this example two 2Mbit modules 46, 47 and a STM1E I/O module 48 have been plugged. The outer right hand connector part 49 of the lower row 45 is not in use. Further a fiber management module 50 has been shown which is directly connected to some circuit packs by an optical fiber connection 51. For the sake of completeness an EMC cover has been shown at 52 and an EMC boundary at 53.

As may appear from the above description rack devices in accordance with the present invention have a back panel which is as small as possible. The extended back panel section has a number of connector parts, which preferably are miniature connector parts and which further preferably are of standardized design. The connector parts in use connect to interface modules in accordance with user specifications and said interface modules again will be used for connection to other equipment. As a result of this lay-out the use of space for the rack device has become flexible, which in some situations may make it possible to place an extra subrack in one and the same cabinet.

It is observed that the embodiments shown are examples of possible embodiments only. Having read the above specification a skilled person will be able to devise modifications without leaving the scope of the invention.

## Claims

1. Rack device for telecommunication equipment including a housing for circuit packs and a back panel having an extended section extending at least at one side of said housing beyond the housing in order to provide a mounting area for at least one interface connector part, **characterized in that** the extended back panel section supports a number of connector parts suitable for connecting to connector parts of a number of interface modules, which again have further connector parts adapted to user specifications for connecting to other equipment.

2. Rack device as claimed in claim 1, **wherein** the extended back panel section is a narrow striplike section.

3. Rack device as claimed in claim 1 or 2, wherein the extended back panel section supports at least one row of connector parts.

4. Rack device as claimed in any one of claims 1-3, **wherein** the connector parts on the extended section are miniature connector parts.

5. Rack device as claimed in any one of claims 1-4 **wherein** the connector parts on the extended section are of standardized design.

6. Rack device system including at least one rack device as claimed in any one of claims 1-5 and a number of interface modules connected to the connector parts of said rack device.

7. Rack device system as claimed in claim 6, **wherein** the interface modules are connectable to the circuit packs through connector parts which in use are directly inserted into the connector parts on the extended section of the back panel.

8. Rack device system as claimed in claim 6 **wherein** the interface modules are connectable to the connector parts on the extended section of the back panel through at least one cable connection having at least one connector part insertable into a corresponding connector part on the back panel.
